# EUROPEAN PATENT APPLICATION

(11) **EP 1 748 486 A2**
(43) Date of publication of application: **31.01.2007**
(21) Application number: 06014015.9
(22) Date of filing: 06.07.2006
(51) Int. Cl.: H01L 23/495, H01L 23/498

(54) **TAB tape carrier**

(30) Priority: 26.07.2005 JP 2005216221
(71) Applicant: NITTO DENKO CORPORATION, Ibaraki-shi, Osaka 567-8680 (JP)
(72) Inventor: Nakamura, Kei, Ibaraki-shi Osaka 567-8680 (JP); Ishimaru, Yasuto, Ibaraki-shi Osaka 567-8680 (JP)
(74) Representative: Schwabe - Sandmair - Marx

(57) **Abstract**

To provide a TAB tape carrier that can provide improved adhesion of a conductive pattern to an insulating base layer, while strengthening a connection between gold terminals of a semiconductor device and connection terminals covered with a tin plating layer, and can prevent the conductive pattern from sinking into the insulating base layer. In the TAB tape carrier 1, an insulating base layer 2 is formed by laminating a thermoplastic polyimide resin layer 2b of 4µm thick or less on a thermosetting polyimide resin layer 2a, and a conductive pattern 7 having inner leads 9 covered with a tin plating layer 13 is formed on a surface of the thermoplastic polyimide resin layer 2b. In this TAB tape carrier 1, even when the gold terminals 22 of the semiconductor device 21 are press-bonded to the inner leads 9 covered with the tin plating layer 13 at high temperatures and pressures, the conductive pattern 7 can be prevented from sinking into the insulating base layer 2.

## Description

### BACKGROUND OF THE INVENTION

### Field of the Invention

The present invention relates to a TAB tape carrier and, more particularly, to a TAB tape carrier used for mounting a semiconductor device by a TAB (tape automated bonding) method.

### Description of the Prior Art

The TAB tape carrier, which is a tape carrier on which semiconductor devices are mounted by the TAB method, is in wide use in the field of electronic components.

A TAB tape carrier having a conductive pattern of a copper foil formed on an insulating base layer of a polyimide resin is generally known as the TAB tape carrier (Cf. JP Laid-open (Unexamined) Patent Publication No. 2004-134442, for example).

In this TAB tape carrier, the conductive pattern is formed in the form of a wiring pattern configured by a plurality of wires each comprising an inner lead, an outer lead, and a relay lead which are integrally formed to extend continuously, and the inner lead and the outer lead are each covered with a nickel plating layer and a gold plating layer.

The semiconductor devices are mounted on the TAB tape carrier in such a manner that after their terminals are press-bonded to the inner leads covered with a nickel plating layer and a gold plating layer, a sealing resin is filled in spaces between the semiconductor devices and the TAB tape carrier.

In recent years, a mounting density of a semiconductor device mounted on the tape carrier has been increased and a finer conductive pattern has been demanded increasingly. The finer the conductive pattern, the smaller a contact area between the conductive pattern and the insulating base layer becomes, so that the conductive pattern comes to be easily stripped from the insulating base layer. On the other hand, when the insulating base layer has a surface area formed from a thermoplastic polyimide resin, adhesion of the insulating base layer to the conductive pattern can be improved.

When terminals of the semiconductor device are formed by gold bumps, the connection strength can be improved by covering the inner leads with a tin plating layer. On the other hand, when the gold bumps are press-bonded to the inner leads covered with the tin plating layer, they are usually press-bonded with a semiconductor device mounting load of about 150N at a mounting temperature of 300°C or more so that an eutectic of gold and tin can be formed on the interface between the both metals to strengthen the bonding.

When a finer conductive pattern is formed on the insulating base layer, which results in a smaller contact area between the conductive pattern and the insulating base layer, an increased surface pressure of the conductive pattern exerts on the insulating base layer when the bonding is carried out in the manner described above. When a surface layer of the insulating base layer is formed of the thermoplastic polyimide layer, in order to try to obtain improved adhesion to the conductive pattern, the conductive pattern sinks into the surface layer of the insulating base layer, with the result that it becomes hard to secure a space between the semiconductor device and the TAB tape carrier. This produces a disadvantageous result that it comes to be difficult to fill the sealing resin in that space, or even when the sealing resin is filled in that space, a void may be formed in the sealing resin.

### SUMMARY OF THE INVENTION

It is an object of the invention to provide a TAB tape carrier that can provide improved adhesion of a conductive pattern to an insulating base layer, while strengthening a connection between gold terminals of a semiconductor device and connection terminals covered with a tin plating layer, and can prevent the conductive pattern from sinking into the insulating base layer.

The present invention provides a TAB tape carrier comprising an insulating base layer including a thermoplastic polyimide resin layer having a thickness of not more than 4µm as a surface layer, and a conductive pattern formed on the insulating base layer, wherein the conductive pattern includes connection terminals for connection with gold terminals of a semiconductor device, and a tin plating payer is formed on a surface of each of the connection terminals.

In the TAB tape carrier of the present invention, it is preferable that a glass transition point of the thermoplastic polyimide resin for forming the thermoplastic polyimide resin layer is not more than 350°C.

In the TAB tape carrier of the present invention, it is preferable that the insulating base layer comprises a thermosetting polyimide resin layer on which the thermoplastic polyimide resin layer is formed, and a coefficient of linear expansion of the thermosetting polyimide resin for forming the thermosetting polyimide resin layer is not more than 30ppm/°C.

According to the TAB tape carrier of the present invention, since the surface layer of the insulating base layer is the thermoplastic polyimide resin layer, even when a finer conductive pattern is formed on the insulating base layer, improved adhesion of the conductive pattern to the insulating base layer can be provided.

Besides, since the thickness of the thermoplastic polyimide resin layer is not more than 4µm, even when the gold terminals of the semiconductor device are press-bonded to the connection terminals covered with the tin plating layer at high temperatures and pressures, for strengthening the connection, the conductive pattern can be prevented from sinking into the insulating base layer. This can provide the result that while the gold terminals of the semiconductor device and the connection terminals covered with the tin plating layer can be tightly connected with each other, a space can be secured between the semiconductor device and the TAB tape carrier so that a sealing resin can be filled in the space therebetween with no difficulty.

### BRIEF DESCRIPTION OF THE DRAWINGS

In the drawings:
FIG. 1 is a partial plan view showing an embodiment of a TAB tape carrier of the present invention;
FIG. 2 is an enlarged plan view of a wiring portion of the TAB tape carrier shown in FIG. 1;
FIG. 3 is a partial bottom view of the TAB tape carrier shown in FIG. 1;
FIG. 4 is a production process drawing showing an embodiment of a production method of the TAB tape carrier shown in FIG. 1 in section taken along the longitudinal direction of the TAB tape carrier,
   (a) showing the process of preparing a stiffening layer,
   (b) showing the process of forming a thermosetting polyimide resin layer on the stiffening layer,
   (c) showing the process of forming a thermoplastic polyimide resin layer on the thermosetting polyimide layer,
   (d) showing the process of forming a thin conductive film on the entire surface of an insulating base layer,
   (e) showing the process of forming a plating resist on the thin conductive film, and
   (f) showing the process of boring feed holes in the TAB tape carrier at both widthwise ends thereof,

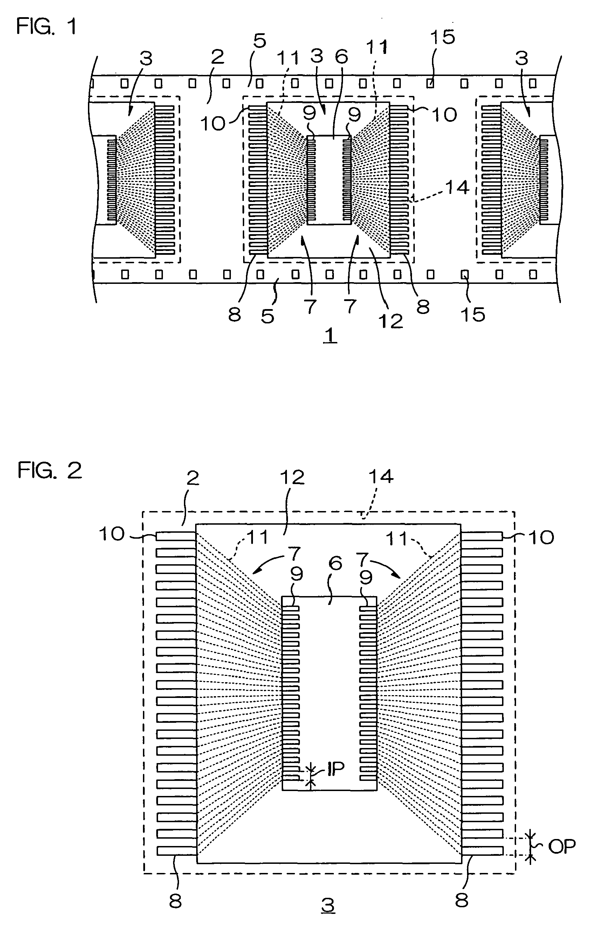

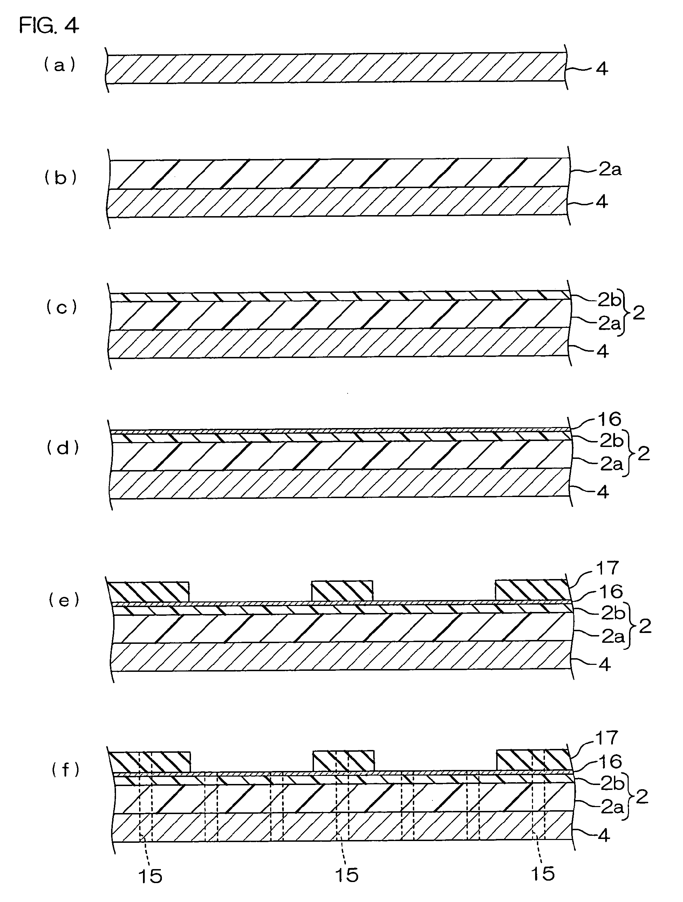

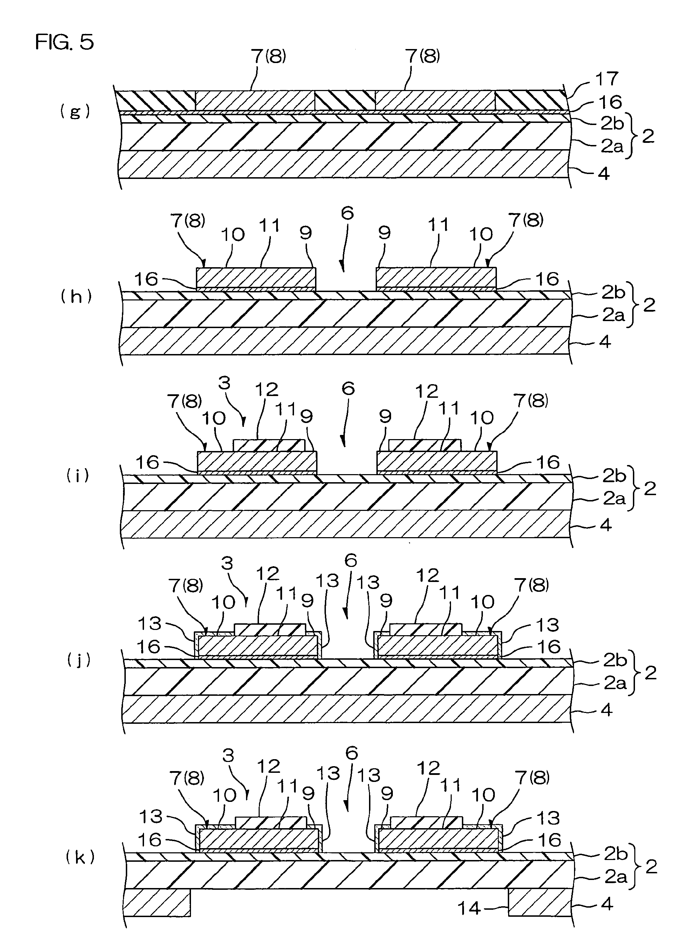

FIG. 5 is a process drawing, which is subsequent to FIG. 4, showing an embodiment of the production method of the TAB tape carrier shown in FIG. 1 in section taken along the longitudinal direction of the TAB tape carrier,
   (g) showing the process of forming a conductive pattern on a surface of the thin conductive film exposed from the plating resist,
   (h) showing the process of removing the plating resist and the thin conductive film exposed from the conductive pattern,
   (i) showing the process of forming an insulating covering layer for covering respective relay leads of wires,
   (j) showing the process of forming a tin plating layer on a surface of each of inner leads and outer leads of the wires, and
   (k) showing the process of forming an opening in the stiffening layer at a location corresponding to the wiring portion, and

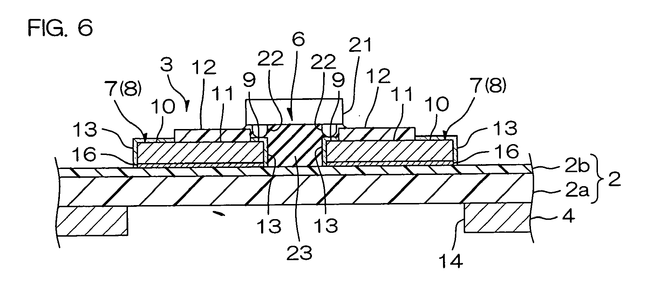

FIG. 6 is a sectional view taken along the longitudinal direction of the TAB tape carrier, showing the state in which a semiconductor device is mounted on the TAB tape carrier shown in FIG. 1.

### DETAILED DESCRIPTION OF THE PREFERRED EMBODIMENT

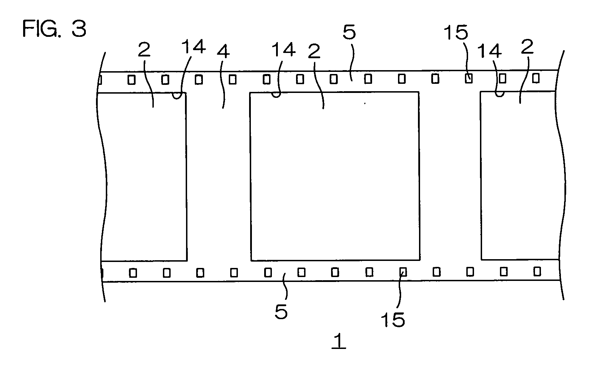

FIG. 1 is a partial plan view showing an embodiment of a TAB tape carrier of the present invention. FIG. 2 is an enlarged plan view of a wiring portion of the TAB tape carrier shown in FIG. 1 and FIG. 3 is a partial bottom view of the TAB tape carrier shown in FIG. 1.

In the TAB tape carrier 1 shown in FIG. 1, wiring portions 3 for forming conductive patterns 7 therein and carrier portions 5 used for carrying the TAB tape carrier 1 are formed on an insulating base layer 2 extending continuously in a longitudinal direction and laminated on a stiffening layer 4 (Cf. FIG. 3).

The wiring portions 3 are spaced from each other at predetermined intervals on a front surface of the insulating base layer 2 along a longitudinal direction thereof (or same as along a longitudinal direction of the TAB tape carrier 1, which is hereinafter sometimes simply referred to as "the longitudinal direction").

As shown in FIG. 2, each wiring portion 3 has, in a center portion thereof, a mounting portion 6 of a generally rectangular form when viewed from top for mounting a semiconductor device 21 (Cf. FIG. 6). Also, conductive patterns 7 are formed at both lengthwise sides of the mounting portion 6.

Each conductor pattern 7 comprises a plurality of wires 8 spaced from each other at predetermined intervals on the front surface of the insulating base layer 2, and each wire 8 comprises an inner lead 9 serving as a connection terminal, an outer lead 10, and a relay lead 11 which are integrally formed to extend continuously.

The inner leads 9 are arranged to face into the mounting portion 6 and extend along the longitudinal direction and are arranged at predetermined spaced locations to be in parallel with each other in a widthwise direction of the TAB tape carrier 1 (or in a direction orthogonal to the longitudinal direction, which is sometimes simply referred to as "the widthwise direction"). A pitch IP of the inner lead 9 (i.e., a total length of a width of an inner lead 9 (a width of its bottom surface) and a space (distance) between two adjoining inner leads 9) is set to fall within the range between 40µm or less, or preferably 30µm or less, and usually 20µm or more. When the pitch IP of the inner lead 9 is set to be 40µm or less, high density wiring can be realized.

The width of a single inner lead 9 (the width of its bottom surface) is set to be in the range of 5-15µm, or preferably 10-15µm, and the space (distance) between two of the adjoining inner leads 9 is set to be in the range of 5-35µm, or preferably 10-20µm.

The outer leads 10 are arranged to face into both lengthwise ends of the wiring portion 3 and extend along the longitudinal direction and are arranged at predetermined spaced locations to be in parallel with each other in the widthwise direction. A pitch OP of the outer lead 10 (i.e., a total length of a width of an outer lead 10 (a width of its bottom surface) and a space (distance) between two adjoining outer leads 10) is set to be, for example, in the range of about 100% to about 1,000% of the pitch IP of the inner lead 9. This means that the pitch OP of the outer lead 10 may be set to be wider than or substantially equal to the pitch IP of the inner lead 9.

The relay leads 11 relay the respective inner leads 9 and the respective outer leads 10 to extend continuously therebetween. When the pitch OP of the outer lead 10 is set to be larger than the pitch IP of the inner lead 9, the outer leads 10 are arranged to radiate out gradually from the inner leads 9 of narrower pitch toward the outer leads 10 of wider pitch.

In a region of the conductive pattern 7 where the respective relay leads 11 are arranged, an insulating cover layer 12, such as a solder resist, is provided to cover the relay leads 11. Specifically, the insulating cover layer 12 is formed in a generally rectangular form when viewed from top to surround the mounting portion 6 so that all relay leads 11 can be covered with the insulating cover layer 12.

Also, a tin plating layer 13 is formed on the inner leads 9 and the outer leads 10 exposed from the insulating cover layer 12 (Cf. FIG. 6).

Carrying portions 5 are formed at both widthwise ends of the TAB tape carrier 1 and arranged along the longitudinal direction, as shown in FIG. 1. A plurality of feed holes 15 are formed in each of the carrying portions 5. The feed holes 15 on one widthwise side and the feed holes 15 on the other widthwise side are arranged respectively to correspond in position to each other in the widthwise direction so that the feed holes 15 can be engaged with sprocket wheels and the like, to carry the TAB tape carrier 1. Each of the feed holes 15 is bored at a regularly spaced location in the longitudinal direction of the TAB tape carrier 1, to extend through the TAB tape carrier 1 (extend through the insulating base layer 2 and the stiffening layer 4). The feed holes 15 are formed in a generally rectangular form viewed from top.

The stiffening layer 4 is laminated on a back surface of the insulating base layer 2, as shown in FIG. 3. In this stiffening layer 4, the feed holes 15 are formed at the both widthwise ends already described, while openings 14 of a generally rectangular form when viewed from bottom are formed to vertically correspond to the respective wiring portions 3.

Next, the production method of this TAB tape carrier 1 will be explained below with reference to FIGS. 4 and 5.

In this method, the stiffening layer 4 is prepared, first, as shown in FIG. 4(a). A copper foil, a stainless foil, and the like is used for the stiffening layer 4. Preferably, the stainless foil is used for the stiffening layer 4. For example, stainless steels in a foil form, such as SUS301, SUS304, SUS305, SUS309, SUS310, SUS316, SUS317, SUS321, and SUS347, may be used in conformity to the standard of AISI (American Iron and Steel Institute). The stiffening layer 4 has a thickness of e.g. 3-100µm, preferably 5-30µm, or further preferably 8-20µm.

Although a line of TAB tape carrier 1 is illustrated in FIGS. 1 to 3, it is usual that a plurality of TAB tape carriers 1 arranged in rows in the widthwise direction of the stiffening layer 4 are produced simultaneously and then are split into each one. For instance, when the stiffening layer 4 having a width of 250mm is used, four rows of TAB tape carriers 1 having a width of 48mm are produced simultaneously, while on the other hand, when the stiffening layer 4 having a width of 300mm is used, four rows of TAB tape carriers 1 having a width of 70mm are produced simultaneously.

Sequentially, the insulating base layer 2 is formed on the stiffening layer 4, as shown in FIG. 4(b) and FIG. 4(c). In the formation of the insulating base layer 2, a thermosetting polyimide resin layer 2a is formed on the stiffening layer 4, first, as shown in FIG. 4(a), and, then, a thermoplastic polyimide resin layer 2b serving as a surface layer of the insulating base layer 2 is formed on the thermosetting polyimide resin layer 2a, as shown in FIG. 4(c).

The thermosetting polyimide resin layer 2a can be formed by a process of coating a resin solution containing a polyimide resin precursor over the stiffening layer 4, first, then drying it, and then curing it by heating.

A polyamic acid resin produced by reaction of, for example, an aromatic tetracarboxylic acid and an aromatic diamine, is used as the polyimide resin precursor. The resin solution can be prepared as a varnish by dissolving e.g. a polyamic acid resin in an organic solvent.

The resin solution can be coated by a known coating method, such as a doctor blade method and a spin coat method. Then, after the resin solution is dried, the coating is cured by heating at e.g. 200-600°C, whereby the thermosetting polyimide resin layer 2a of thermosetting polyimide resin is formed on the stiffening layer 4.

The thermosetting polyimide resin layer of the thermosetting polyimide resin layer 2a thus formed has a coefficient of linear expansion which falls within the range between e.g. 30ppm/°C or less or preferably 25ppm/°C or less, and usually 18ppm/°C or more.

The thermosetting polyimide resin layer 2a can be formed in the form of a predetermined pattern by the process that after a known photosensitizing agent is mixed in the resin solution, the resin solution is coated over the stiffening layer 4 and then is exposed to light and then developed.

The thermosetting polyimide resin layer 2a has a thickness of e.g. 5-50µm, preferably 10-40µm, or further preferably 20-30µm.

The thermoplastic polyimide resin layer 2b is formed by a process of coating a resin solution containing a thermoplastic polyimide resin over the thermosetting polyimide resin layer 2a and then drying it.

The thermoplastic polyimide resins that may be used include, for example, a polyether imide resin, a polyamide imide resin, and a polyester imide resin. The resin solution can be prepared as a varnish by dissolving e.g. a thermoplastic polyimide resin in an organic solvent.

The resin solution can be coated by a known coating method, such as the doctor blade method and the spin coat method. Then, the resin solution coated is dried. The thermoplastic polyimide resin layer 2b of thermoplastic polyimide resin is formed on the thermosetting polyimide resin layer 2a in the manner already described.

A glass transition point (Tg) of the thermoplastic polyimide resin of the thermoplastic polyimide resin layer 2b thus formed is not more than a press-bonding temperature of the semiconductor device 21 (a temperature of a press-bonding or crimping tool). For example, the glass transition point (Tg) of the thermoplastic polyimide resin is in the range of between 350°C or less or preferably 300°C or less, and 250°C or more. When the thermoplastic polyimide resin has a glass transition point (Tg) of not more than 350°C, the thermoplastic polyimide resin layer 2b can adhere to the conductive pattern 7 with improved adhesion.

The thermoplastic polyimide resin layer 2b can be provided also in the form that a dry film of a previously processed thermoplastic polyimide resin is adhered to the thermosetting polyimide resin layer 2a via an adhesive.

The thermoplastic polyimide resin layer 2b has a thickness of e.g. 4µm or less, or preferably 1-4µm, or further preferably 1-2.5µm.

When the thickness of the thermoplastic polyimide resin layer 2b is in excess of 4µm, there is a possibility that when the semiconductor device 21 is press-bonded to the conductive pattern 7, the conductive pattern 7 may sink into the thermoplastic polyimide resin layer 2b, and as such may make it difficult to secure the space between the semiconductor device 21 and the TAB tape carrier 1. In contrast to this, when the thickness of the thermoplastic polyimide resin layer 2b is not more than 4µm, the conductive pattern 7 can be prevented from sinking into the thermoplastic polyimide resin layer 2b, while ensuring the adhesion of the conductive pattern 7 to the thermoplastic polyimide resin layer 2b.

In order to well ensure the adhesion between the insulating base layer 2 and the conductive pattern 7, the thermoplastic polyimide resin 2b preferably has a thickness of not less than 1µm,

The insulating base layer 2 thus formed has a thickness of between e.g. 50µm or less, preferably 30µm or less, or further preferably 15µm or less and usually 3µm or more.

Sequentially, the conductive pattern 7 is formed in the form of the wiring pattern configured by the wires 8 described above. The materials used for forming the conductive pattern 7 include, for example, copper, nickel, gold, solder or alloys thereof. Copper is preferably used for forming the conductive pattern 7. The conductive pattern 7 is formed on the front surface of the insulating base layer 2 in the form of the wiring pattern configured by the wires 8 by a known patterning process, such as, for example, a subtractive process and an additive process, without any limitation thereon.

In the subtractive process, the conductive layer is laminated on the entire area of the front surface of the insulating base layer 2 via an adhesive layer, if necessary. Then, an etching resist having a pattern corresponding to the wiring pattern configured by the wires 8 is formed on the conductive layer. Then, the conductive layer is etched with the etching resist as a resist, and the etching resist is removed thereafter.

In the additive process, a thin conductive film serving as a seed film (a base) is formed on the front surface of the insulating base layer 2, first, and, then, a plating resist having a reverse pattern to the wiring pattern 8 described above is formed on a front surface of the thin conductive film. Then, the conductive pattern 7 which is in the form of the wiring pattern 8 described above is formed on the front surface of the thin conductive film exposed from the plating resist by plating. Thereafter, the thin conductive film is removed except the part corresponding to the plating resist and the conductive pattern.

These patterning processes produce different results as follows: When the conductive pattern 7 is formed by the subtractive process, the lines of wires 8 are formed by etching the conductive layer. As a result, a width of an upper surface of the wire 8 (i.e. a length of a contact surface of the wire 8 contacting with the insulating cover layer 12 extending orthogonally to a direction for the wire 8 to extend)/ a width of a bottom surface of the wire 8 (i.e. a length of a contact surface of the wire 8 contacting with the insulating base layer 2 extending orthogonally to the direction for the wire 8 to extend) comes to be less than 1. In short, each wire 8 comes to have a trapezoidal section which gradually reduces in width from the bottom toward the top.

On the other hand, when the conductive pattern 7 is formed by the additive process, the lines of wires 8 are formed on a surface of the thin conductive film between the plating resists by precipitation of the plate. As a result, the width of the upper surface of the wire 8/ the width of the bottom surface of the wire 8 comes to be substantially equal to or more than 1. In short, each wire 8 comes to have a trapezoidal section having the bottom surface substantially equal in width to, or larger than the top surface.

In terms of the advantage described above, the additive process is preferably used for forming a finer conductive pattern 7 to realize a high density wiring.

In the additive process, the thin conductive film 16 serving as the seed film (the base) is formed on the entire area of the front surface of the insulating base layer 2, as shown in FIG. 4(d). A method, such as vacuum deposition or preferably sputtering vapor deposition is used for forming the thin conductive film 16. Also, chromium and copper are preferably used as the conductor for forming the thin conductive film 16.

To be more specific, it is preferable that, for example, a thin chromium film and a thin copper film are formed on the entire area of the front surface of the insulating base layer 2 sequentially by the sputtering vapor deposition method. Also, it is preferable that when forming the thin conductive film 16, the thin chromium film and the thin copper film are set to have a thickness of 100-600Å and 500-2,000□, respectively.

Then, the plating resist 17 having a reversal pattern reverse to the above-mentioned wiring pattern configured by the wires 8 is formed on the thin conductive film 16, as shown in FIG. 4(e). The plating resist 17 is formed in the reverse pattern by a known process of, for example, exposing a dry film photoresist to light and then developing it.

Thereafter, a plurality of feed holes 15 are bored at both widthwise end portions of the TAB tape carrier 1 along the longitudinal direction, to extend through the stiffening layer 4, the insulating base layer 2, the thin conductive film 16, and the plating resist 17 in the thickness direction thereof, as shown in FIG. 4(f). These feed holes 15 can be bored by a known process, such as, for example, drilling, laser processing, punching, and etching. The punching is preferably used for forming the feed holes 15.

Sequentially, the conductive pattern 7 in the form of the wiring pattern 8 is formed on the front surface of the thin conductive film 16 exposed from the plating resist 17 by plating, as shown in FIG. 5(g). An electrolytic plating and an electroless plating may be used for forming the conductive pattern 7. Preferably, an electrolytic plating is used. More preferably, an electrolytic copper plating is used therefor.

Then, the plating resist 17 is removed by a known etching process, such as a chemical etching (wet etching) or by stripping, as shown in FIG. 5(h). Thereafter, the thin conductive film 16 exposed from the conductive pattern 7 is also removed by a known etching process, such as the chemical etching, as shown in FIG. 5(h).

As a result of this, the conductive pattern 7 is formed on the insulating base layer 2 in the form of the pattern configured by the wires 8 each comprising the inner lead 9, the outer lead 10, and the relay lead 11 which are integrally formed to extend continuously. The conductive patterns 7 thus formed have a thickness of e.g. 5µm or more, or preferably 8-15µm.

Then, the insulating cover layer 12 is formed in a form like a rectangular frame when viewed from top to cover the relay leads 11 of the wires 8 and surround the mounting portion 6, as shown in FIG. 5(i). The insulating cover layer 12 is formed by a known method using a photosensitive solder resist and the like. The insulating cover layer 12 has a thickness of e.g. 5-30µm or preferably 5-20µm.

Thereafter, a tin plating layer 13 is formed on the front surface of the inner lead 9 and outer lead 10 of each wire 8, as shown in FIG. 5(j). The tin plating layer 13 is formed to cover the front surface of the inner lead 9 and outer lead 10 of each wire 8 by the electroless tin plating, for example.

Then, an opening 14 is formed in the stiffening layer 4 at a location thereof corresponding to the wiring portion 3, as shown in FIG. 5(k). The TAB tape carrier 1 is produced in the manner mentioned above.

The opening 14 is formed in the stiffening layer 4 by opening the stiffening layer 4 at the location thereof corresponding to the wiring portion 3 by a known process, such as, for example, drilling, punching, and wet etching (chemical etching). Take the etching for instance, after the entire area of the stiffening layer 4, except the part the opening 14 is formed, is covered with the etching resist, the stiffening layer 4 is etched using a known etching solution, such as a solution of ferric chloride and, thereafter, the etching resist is removed.

In the case where the TAB tape carriers 1 arranged in rows in the widthwise direction of the stiffening layer 4 are produced simultaneously and then are split into each, splits are formed between the respective TAB tape carriers 1 by removing the stiffening layer 4 at the same time that the openings 14 are formed. In the case where the TAB tape carriers 1 arranged in rows in the widthwise direction of the stiffening layer 4 are produced separately, they are split into each one.

In the TAB tape carrier 1 thus produced, since a finer conductive pattern 7, and a high density wiring are realized, thus the semiconductor device 7 can be mounted with a high mounting density.

The denser the conductive pattern 7 is wired, the smaller the contact area between the conductive pattern 7 and the insulating base layer 2 becomes. In this TAB tape carrier 1, since the conductive pattern 7 is formed on the front surface of the thermoplastic polyimide resin layer 2b, adhesion of the conductive pattern 7 with the insulating base layer 2 can be improved.

In addition, since the inner lead 9 is covered with the tin plating layer 13, when gold terminals (gold bumps) 22 of the semiconductor deice 21 are connected with the inner lead 9 covered with the tin plating layer 13 in the mounting portion 6 by press-bonding, as shown in FIG. 6, the connection strength can be improved.

On the other hand, when the gold terminals 22 of the semiconductor device 21 are press-bonded to the inner leads 9 covered with the tin plating layer 13, they are usually crimped with a semiconductor device mounting load of 50N or more, or preferably 100-150N, at a mounting temperature of usually 300°C or more, or preferably 400-450°C, so that an eutectic of gold and tin can be formed on the interface between the both metals to strengthen the bonding.

When a finer conductive pattern 7 is formed on the insulating base layer 2, which results in a smaller contact area between the conductive pattern 7 and the insulating base layer 2, an increased surface pressure exerts on the insulating base layer 2 when the bonding is carried out in the manner described above. Particularly when such a finer conductive pattern 7 is formed by the additive process, the width of the upper surface of the wire 8/the width of the bottom surface of the wire 8 comes to be substantially equal to or more than 1, so that a further increased surface pressure exerts on the thermoplastic polyimide resin layer 2b through the bottom of the conductive pattern 7. As a result of this, the conductive pattern 7 is press-bonded to the insulating base layer 2 so strongly that it sinks into the insulating base layer 2.

However, in this TAB tape carrier 1, since the thermoplastic polyimide resin layer 2b has a thickness of 4µm or less, an amount of dent of the insulating base layer 2 pressed by the conductive pattern 7 can be reduced to prevent the conductive pattern 7 from sinking into the insulating base layer 2. This can secure the space between the semiconductor device 21 and the TAB tape carrier 1 and ensure that after the press-bonding, the sealing resin 23 can be filled in between the semiconductor device 21 and the TAB tape carrier 1 without any trouble and without forming any void in the sealing resin. As a result, the semiconductor device 21 can be surely mounted on the mounting portion 6.

Although the TAB tape carrier 1 which is in the form of a single sided wired circuit board having the wiring portion 3 formed on one side of the insulating base layer 2 has been illustrated above, the TAB tape carrier 1 of the present invention may be formed in the form of, for example, a double sided wired circuit board having the wiring portions 3 on both sides of the insulating base layer 2. When the TAB tape carrier 1 is formed as the double sided wired circuit board, a plurality of wiring portions 3, rather than the stiffening layer 4, are formed on the back side of the insulating base layer 2, as in the case of the front side of the insulating base layer 2.

### Examples

In the following, the present invention will be described in further detail with reference to Examples and Comparative Example.

### Example 1

In the example 1, four lines of TAB tape carriers of 48mm wide were simultaneously produced on a stiffening layer of 250mm wide.

A stiffening layer of a stainless foil (SUS304) having a thickness of 20µm thick was prepared, first (Cf. FIG. 4(a)). Then, a solution of polyamic acid resin was coated over the stiffening layer and then dried. Thereafter, the coating was cured by heating to form a thermosetting polyimide resin layer having a thickness of 20µm (Cf. FIG. 4(b)). A coefficient of linear expansion of the thermosetting polyimide resin thus formed was 20ppm/°C.

Then, a solution of thermoplastic polyimide resin polyamic acid resin consisting primarily of an aliphatic polyimide was coated over the thermosetting polyimide resin layer and then dried, to thereby form a thermoplastic polyimide resin layer having a thickness of 1µm was formed (Cf. FIG. 4(c)). A glass transition point of the thermoplastic polyimide resin layer thus formed was 300°C.

The insulating base layer comprising the thermosetting polyimide resin layer and the thermoplastic polyimide resin layer which were sequentially laminated on the stiffening layer was formed in the manner described above.

Then, a thin chromium film and a thin copper film were formed on the front surface of the insulating base layer sequentially by a sputtering vapor deposition, thereby forming a thin metal film having a thickness of 2,000□ (Cf. FIG. 4(d)).

Then, a plating resist was formed on a front surface of the thin metal film in the form of a reverse pattern reverse to the conductive pattern by a process of exposing a dry film photoresist to light and then developing it (Cf. FIG. 4(e)). Thereafter, feed holes were bored by a punching process, to extend through the stiffening layer, the insulating base layer, the metal film, and the plating resist in the thickness direction thereof (Cf. FIG. 4(f)).

Sequentially, it was dipped in an electrolytic plating solution of copper sulfate for about twenty minutes at 2.5A/dm² to form a conductive pattern having a thickness of 10µm on the front surface of the thin metal film exposed from the plating resist by electrolytic copper plating (Cf. FIG. 5(g)).

Each of the conductor patterns was formed in a wiring pattern configured by a plurality of wires arranged at predetermined spaced locations, each wire comprising an inner lead, an outer lead, and a relay lead which were integrally formed to extend continuously. A pitch of the inner lead was 30µm, and a pitch of the outer lead was 100µm.

Then, the plating resist was removed by a chemical etching and, thereafter, the thin conductive film exposed from the conductive pattern was also removed by the same chemical etching (Cf. FIG. 5(h)).

Thereafter, an insulating cover layer was formed using a photosensitive solder resist, to cover the relay leads of the wires and surround the mounting portion (Cf. FIG. 5(i)). Thereafter, a tin plating layer was formed on a front surface of the inner lead and outer lead by electroless tin plating (Cf. FIG. 5(j)).

Then, after the entire surface of the stiffening layer, except portions thereof corresponding to the wiring portions therein, was covered with an etching resist, the stiffening layer was etched using a solution of ferric chloride, to form slits between openings and the TAB tape carriers. Then, after the etching resist was removed, the TAB tape carriers were slit to obtain the TAB tape carriers.

### Examples 2 and 3 and Comparative Example 1

Except that the thermoplastic polyimide resin layer was varied in thickness, such as 3µm thick in Example 2, 4µm thick in Example 3, and 5µm thick in Comparative Example 1, the same processes as those of Example 1 were taken to produce the respective TAB tape carriers.

### Evaluation

Semiconductor devices having gold bumps were mounted on the mounting portions of the TAB tape carriers obtained in Examples 1 to 3 and Comparative example 1. In the mounting of the semiconductor device, the gold bumps were placed opposite to the inner leads covered with the tin plating layer and then were press-bonded thereto with a mounting load of 130N at a mounting temperature (a temperature of a press-bonding or crimping tool) of 325°C. After the press-bonding, an amount of dent of the insulating base layer was measured. The results are shown in TABLE 1.

Then, a liquid under-fill sealing resin was filled in between the semiconductor device and the TAB tape carrier. Thereafter, the sealing resin was observed to ascertain presence of a void in the sealing resin. The results are shown in TABLE 1.

**TABLE 1**

| Examples and Comparative Example | Example 1 | Example 2 | Example 3 | Comparative example 1 |
|---|---|---|---|---|
| Thickness of thermoplastic polyimide resin layer (µm) | 1 | 3 | 4 | 5 |
| Dent of insulating base layer (µm) | 0 | 0.9 | 1.7 | 2.5 |
| Presence of void in sealing resin | Not found | Not found | Not found | Found |

While the illustrative embodiments of the present invention are provided in the above description, such is for illustrative purpose only and it is not to be construed restrictively. Modification and variation of the present invention that will be obvious to those skilled in the art is to be covered by the following claims.

## Claims

1. A TAB tape carrier comprising an insulating base layer including a thermoplastic polyimide resin layer having a thickness of not more than 4µm as a surface layer, and a conductive pattern formed on the insulating base layer, wherein
the conductive pattern includes connection terminals for connection with gold terminals of a semiconductor device, and
a tin plating layer is formed on a surface of each of the connection terminals.

2. The TAB tape carrier according to Claim 1, wherein a glass transition point of the thermoplastic polyimide resin for forming the thermoplastic polyimide resin layer is not more than 350°C.

3. The TAB tape carrier according to Claim 2, wherein the insulating base layer comprises a thermosetting polyimide resin layer on which the thermoplastic polyimide resin layer is formed, and a coefficient of linear expansion of the thermosetting polyimide resin for forming the thermosetting polyimide resin layer is not more than 30ppm/°C.
